# EUROPEAN PATENT APPLICATION

(11) **EP 4 700 758 A1**
(43) Date of publication of application: **25.02.2026**
(21) Application number: 25195532.4
(22) Date of filing: 12.08.2025
(51) Int. Cl.: G09G 3/3233

(54) **PIXEL, DISPLAY DEVICE INCLUDING THE SAME, AND ELECTRONIC DEVICE**

(30) Priority: 22.08.2024 KR 20240112767
(71) Applicant: Samsung Display Co., Ltd., Yongin-si, Gyeonggi-do 17113 (KR)
(72) Inventor: PARK, Jun Hyun, 17113 Yongin-si (KR); LEE, Cheol Gon, 17113 Yongin-si (KR); JEON, Mu Kyung, 17113 Yongin-si (KR)
(74) Representative: Taor, Simon Edward William

(57) **Abstract**

A pixel includes a first transistor for generating a driving current, and including a control electrode connected to a first node, a first electrode, and a second electrode connected to a second node, a second transistor including a control electrode for receiving a write gate signal, a first electrode for receiving a data voltage, and a second electrode connected to a third node, a first capacitor including a first electrode connected to the first node, and a second electrode connected to the third node, a second capacitor including a first electrode, and a second electrode connected to the third node, and a light-emitting element for emitting light by receiving the driving current.

## Description

### CROSS-REFERENCE TO RELATED APPLICATION

The present application claims priority to, and the benefit of, Korean Patent Application No. 10-2024-0112767, filed on August 22, 2024, in the Korean Intellectual Property Office.

### BACKGROUND

### 1. Field

The disclosure relates to a pixel, a display device including the same, and an electronic device.

### 2. Description of the Related Art

As information technology develops, importance of a display device, which is a connection medium between a user and information, is emerging. In response to this, a use of a display device, such as a liquid crystal display device, an organic light-emitting display device, and an inorganic light-emitting display device is increasing.

### SUMMARY

An aspect of the disclosure is to provide a pixel implementing high resolution.

Another aspect of the disclosure is to provide an electronic device and a display device including a pixel.

To achieve an aspect of the disclosure, according to embodiments of the disclosure, a pixel may include a first transistor for generating a driving current, and including a control electrode connected to a first node, a first electrode, and a second electrode connected to a second node, a second transistor including a control electrode for receiving a write gate signal, a first electrode for receiving a data voltage, and a second electrode connected to a third node, a first capacitor including a first electrode connected to the first node, and a second electrode connected to the third node, a second capacitor including a second electrode, and a first electrode connected to the third node, and a light-emitting element for emitting light by receiving the driving current.

The pixel may further include a fourth transistor including a control electrode for receiving a reference gate signal, a first electrode connected to the second node, and a second electrode connected to the third node.

The first transistor may be an N-channel metal oxide semiconductor (NMOS) transistor.

The pixel may further include a seventh transistor including a control electrode for receiving a bias gate signal, a first electrode for receiving an initialization voltage, and a second electrode connected to the light-emitting element.

The pixel may further include a fifth transistor including a control electrode for receiving a first emission signal, a first electrode for receiving a first power voltage, and a second electrode connected to the first transistor, and a sixth transistor including a control electrode for receiving a second emission signal, a first electrode connected to the first transistor, and a second electrode connected to the light-emitting element.

The pixel may further include a seventh transistor including a control electrode for receiving the first emission signal, a first electrode for receiving an initialization voltage, and a second electrode connected to the light-emitting element.

The seventh transistor may include a type that is different from that of the fifth transistor.

The pixel may further include a third transistor including a control electrode for receiving a reference gate signal, a first electrode for receiving a reference voltage, and a second electrode connected to the first node.

The pixel may further include a third transistor including a control electrode for receiving a reference gate signal, a first electrode for receiving a first power voltage, and a second electrode connected to the first node.

The first transistor may further include a back gate electrode connected to the second node.

The first transistor may further include a back gate electrode connected to an anode electrode of the light-emitting element.

The pixel may further include a first electrode layer including the second electrode of the second capacitor, a second electrode layer above the first electrode layer, and including the second electrode of the first capacitor and the first electrode of the second capacitor, an additional electrode layer above the second electrode layer, and including a first electrode pattern including a back gate electrode of the first transistor, and a second electrode pattern including the first electrode of the first capacitor, an active layer above the additional electrode layer, and including a channel area of the first transistor, and a third electrode layer above the active layer, including the control electrode of the first transistor, and electrically connected to the second electrode pattern.

The pixel may further include a first electrode layer including the first electrode of the first capacitor, a second electrode layer above the first electrode layer, and including the second electrode of the first capacitor and the first electrode of the second capacitor, an additional electrode layer above the second electrode layer, and including a first electrode pattern including a back gate electrode of the first transistor, and a second electrode pattern including the second electrode of the second capacitor, an active layer above the additional electrode layer, and including a channel area of the first transistor, and a third electrode layer above the active layer, including the control electrode of the first transistor, and electrically connected to the first electrode layer.

To achieve an aspect of the disclosure, according to embodiments of the disclosure, a pixel may include a first transistor including a control electrode connected to a first node, a first electrode, and a second electrode connected to a second node, a fourth transistor including a control electrode for receiving a reference gate signal, a first electrode connected to the second node, and a second electrode connected to a third node, a first capacitor including a first electrode connected to the first node, and a second electrode connected to the third node, a second capacitor including a second electrode, and a first electrode connected to the third node, and a light-emitting element for emitting light by receiving the driving current.

To achieve an aspect of the disclosure, according to embodiments of the disclosure, a display device may include a display panel including a pixel, and a display panel driver configured to drive the display panel, wherein the pixel includes a first transistor for generating a driving current, and including a control electrode connected to a first node, a first electrode, and a second electrode connected to a second node, a second transistor including a control electrode for receiving a write gate signal, a first electrode for receiving a data voltage, and a second electrode connected to a third node, a first capacitor including a first electrode connected to the first node, and a second electrode connected to the third node, a second capacitor including a second electrode, and a first electrode connected to the third node, and a light-emitting element for emitting light by receiving the driving current.

The pixel may further include a fourth transistor including a control electrode for receiving a reference gate signal, a first electrode connected to the second node, and a second electrode connected to the third node.

The first transistor may include an N-channel metal oxide semiconductor (NMOS) transistor.

The pixel may further include a seventh transistor including a control electrode for receiving a bias gate signal, a first electrode for receiving an initialization voltage, and a second electrode connected to the light-emitting element.

The pixel may further include a fifth transistor including a control electrode for receiving a first emission signal, a first electrode for receiving a first power voltage, and a second electrode connected to the first transistor, a sixth transistor including a control electrode for receiving a second emission signal, a first electrode connected to the first transistor, and a second electrode connected to the light-emitting element, and a seventh transistor including a control electrode for receiving the first emission signal, a first electrode for receiving an initialization voltage, and a second electrode connected to the light-emitting element.

The pixel may further include a fifth transistor including a control electrode for receiving a first emission signal, a first electrode for receiving a first power voltage, and a second electrode connected to the first transistor, a sixth transistor including a control electrode for receiving a second emission signal, a first electrode connected to the first transistor, and a second electrode connected to the light-emitting element, and wherein the display panel driver is configured to adjust an off duty ratio of at least one of the first emission signal and the second emission signal according to an emission off ratio.

The display panel driver may be configured to adjust an off duty ratio of the second emission signal according to the emission off ratio.

The pixel may further include a third transistor including a control electrode for receiving a reference gate signal, a first electrode for receiving a reference voltage, and a second electrode connected to the first node.

The pixel may further include a third transistor including a control electrode for receiving a reference gate signal, a first electrode for receiving a first power voltage, and a second electrode connected to the first node.

The first transistor may further include a back gate electrode connected to the second node.

The first transistor may further include a back gate electrode connected to an anode electrode of the light-emitting element.

To achieve an aspect of the disclosure, according to embodiments of the disclosure, an electronic device may include a processor to provide input image data, and a display device to display an image based on the input image data, and including a display panel including a pixel, and a display panel driver configured to drive the display panel, wherein the pixel includes a first transistor for generating a driving current, and including a control electrode connected to a first node, a first electrode, and a second electrode connected to a second node, a second transistor including a control electrode for receiving a write gate signal, a first electrode for receiving a data voltage, and a second electrode connected to a third node, a first capacitor including a first electrode connected to the first node, and a second electrode connected to the third node, a second capacitor including a second electrode, and a first electrode connected to the third node, and a light-emitting element for emitting light by receiving the driving current.

According to an aspect, there is provided a pixel as set out in claim 1. Additional features are set out in claims 2 to 11. According to an aspect, there is provided a display device as set out in claim 12. Additional features are set out in claims 13 and 14. According to an aspect, there is provided an electronic device as set out in claim 15.

The pixel according to embodiments of the disclosure may implement high resolution by connecting two capacitors in series.

The display device and the electronic device according to embodiments of the disclosure may reduce a used line by providing the first emission signal to the control electrode of the seventh transistor. Accordingly, the display device may implement high resolution.

The pixel according to embodiments of the disclosure may reduce or minimize an influence on a voltage written to the first capacitor due to the driving current because the first capacitor to which a data voltage is written is not directly connected to the second electrode of the first transistor. Accordingly, an error of threshold voltage compensation may be reduced.

However, an aspect of the disclosure is not limited to the above-described effect, and may be variously expanded within a range that does not deviate from the scope of the disclosure.

### BRIEF DESCRIPTION OF THE DRAWINGS

The above and other aspects of the disclosure will become more apparent by describing in further detail embodiments thereof with reference to the accompanying drawings, in which:
FIG. 1 is a block diagram illustrating a display device according to embodiments of the disclosure;
FIG. 2 is a circuit diagram illustrating an example of a pixel of the display device of FIG. 1;
FIG. 3 is a cross-sectional view illustrating an example of a first transistor and first and second capacitors of FIG. 2;
FIG. 4 is a conceptual diagram illustrating a driving operation of the display device of FIG. 1;
FIGS. 5 to 9 are drawings illustrating an example in which the display device of FIG. 1 performs a display scan operation;
FIG. 10 is a timing diagram illustrating an example in which the display device of FIG. 1 performs a self-scan operation;
FIG. 11 is a circuit diagram illustrating a pixel of a display device according to embodiments of the disclosure;
FIG. 12 is a timing diagram illustrating an example in which the display device of FIG. 11 performs a display scan operation;
FIG. 13 is a timing diagram illustrating an example in which the display device of FIG. 11 performs a self-scan operation;
FIG. 14 is a circuit diagram illustrating a pixel of a display device according to embodiments of the disclosure;
FIG. 15 is a circuit diagram illustrating a pixel of a display device according to embodiments of the disclosure;
FIG. 16 is a circuit diagram illustrating a pixel of a display device according to embodiments of the disclosure;
FIG. 17 is a circuit diagram illustrating a pixel of a display device according to embodiments of the disclosure;
FIG. 18 is a circuit diagram illustrating a pixel of a display device according to embodiments of the disclosure;
FIG. 19 is a circuit diagram illustrating a pixel of a display device according to embodiments of the disclosure; and
FIG. 20 is a block diagram illustrating an electronic device according to embodiments of the disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing one or more embodiments corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, embodiments of the disclosure are not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "secondcategory (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact and individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

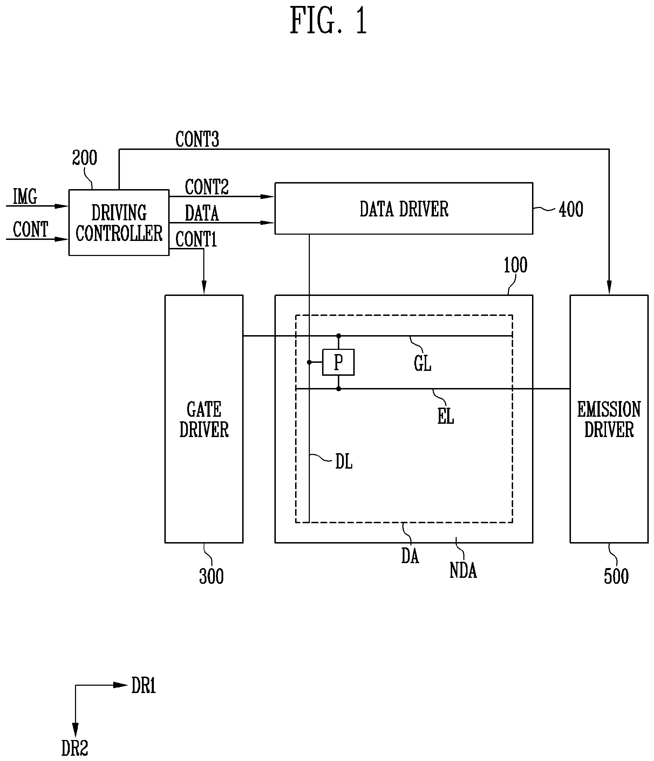

FIG. 1 is a block diagram illustrating a display device according to embodiments of the disclosure.

Referring to FIG. 1, the display device may include a display panel 100, a driving controller 200, a gate driver 300, a data driver 400, and an emission driver 500. In one or more embodiments, the driving controller 200 and the data driver 400 may be integrated into one chip. The driving controller 200 may be referred to as a display panel driver.

The display panel 100 may include a display area DA for displaying an image, and a non-display area NDA located adjacent to the display area DA. In one or more embodiments, the gate driver 300 and the emission driver 500 may be mounted in the non-display area NDA.

The display panel 100 may include a plurality of gate lines GL, a plurality of data lines DL, a plurality of emission lines EL, and a plurality of pixel P electrically connected to the gate lines GL, the data lines DL, and the emission lines EL. The gate lines GL and the emission lines EL may extend in a first direction DR1, and the data lines DL may extend in a second direction DR2 crossing the first direction DR1.

The driving controller 200 may receive input image data IMG and an input control signal CONT from a main processor (for example, a graphic processing unit (GPU) or the like). For example, the input image data IMG may include red image data, green image data, and blue image data. In one or more embodiments, the input image data IMG may further include white image data. As another example, the input image data IMG may include magenta image data, yellow image data, and cyan image data. The input control signal CONT may include a master clock signal and a data enable signal. The input control signal CONT may further include a vertical synchronization signal and a horizontal synchronization signal.

The driving controller 200 may generate a first control signal CONT1, a second control signal CONT2, a third control signal CONT3, and a data signal DATA based on the input image data IMG and the input control signal CONT.

The driving controller 200 may generate the first control signal CONT1 for controlling an operation of the gate driver 300 based on the input control signal CONT, and may output the first control signal CONT1 to the gate driver 300. The first control signal CONT1 may include a vertical start signal and a gate clock signal.

The driving controller 200 may generate the second control signal CONT2 for controlling an operation of the data driver 400 based on the input control signal CONT, and may output the second control signal CONT2 to the data driver 400. The second control signal CONT2 may include a horizontal start signal and a load signal.

The driving controller 200 may generate the data signal DATA by receiving the input image data IMG and the input control signal CONT. The driving controller 200 may output the data signal DATA to the data driver 400.

The driving controller 200 may generate the third control signal CONT3 for controlling an operation of the emission driver 500 based on the input control signal CONT, and may output the third control signal CONT3 to the emission driver 500. The third control signal CONT3 may include a vertical start signal and an emission clock signal.

The gate driver 300 may generate gate signals for driving the gate lines GL in response to the first control signal CONT1 received from the driving controller 200. The gate driver 300 may output the gate signals to the gate lines GL. For example, the gate driver 300 may sequentially output the gate signals to the gate lines GL.

The data driver 400 may receive the second control signal CONT2 and the data signal DATA from the driving controller 200. The data driver 400 may generate data voltages obtained by converting the data signal DATA into an analog voltage. The data driver 400 may output the data voltages to the data line DL.

The emission driver 500 may generate emission signals for driving the emission lines EL in response to the third control signal CONT3 received from the driving controller 200. The emission driver 500 may output the emission signals to the emission lines EL. For example, the emission driver 500 may sequentially output the emission signals to the emission lines EL.

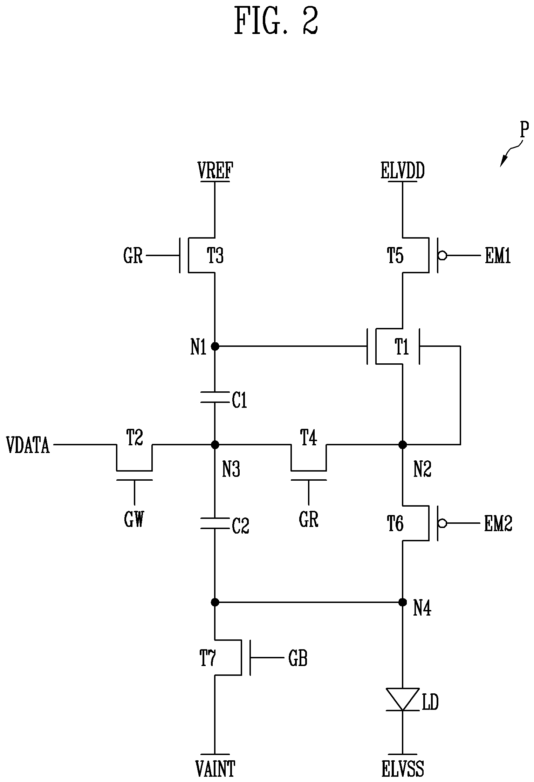

FIG. 2 is a circuit diagram illustrating an example of the pixel of the display device of FIG. 1.

Referring to FIG. 2, each of the pixels P may include a first transistor T1 including a control electrode connected to a first node N1, a first electrode connected to a second electrode of a fifth transistor T5, a second electrode connected to a second node N2, and a back gate electrode connected to the second node N2, a second transistor T2 including a control electrode for receiving a write gate signal GW, a first electrode for receiving a data voltage VDATA, and a second electrode connected to a third node N3, a third transistor T3 including a control electrode for receiving a reference gate signal GR, a first electrode for receiving a reference voltage VREF, and a second electrode connected to the first node N1, a fourth transistor T4 including a control electrode for receiving a reference gate signal GR, a first electrode connected to the second node N2, and a second electrode connected to the third node N3, a fifth transistor T5 including a control electrode for receiving a first emission signal EM1, a first electrode for receiving a first power voltage ELVDD (for example, a high power voltage), and the second electrode connected to the first electrode of the first transistor T1, a sixth transistor T6 including a control electrode for receiving a second emission signal EM2, a first electrode connected to the second node N2, and a second electrode connected to a fourth node N4, a seventh transistor T7 including a control electrode for receiving a bias gate signal GB, a first electrode for receiving an initialization voltage VAINT, and a second electrode connected to the fourth node N4, a first capacitor C1 including a first electrode connected to the first node N1 and a second electrode connected to the third node N3, a second capacitor C2 including a first electrode connected to the third node N3 and a second electrode connected to the fourth node N4, and a light-emitting element LD including an anode electrode connected to the fourth node N4 and a second electrode for receiving a second power voltage ELVSS (for example, a low power voltage).

Hereinafter, it is assumed that the first to fourth and seventh transistors T1, T2, T3, T4, and T7 are implemented as N-channel metal oxide semiconductor (NMOS) transistors, and the fifth and sixth transistors T5 and T6 are implemented as P-channel metal oxide semiconductor (PMOS) transistors. For example, the first to fourth and seventh transistors T1, T2, T3, T4, and T7 may be N-type oxide thin film transistors, and the fifth and sixth transistors T5 and T6 may be P-type silicon thin film transistors. In one or more other embodiments, the first to fourth and seventh transistors T1, T2, T3, T4, and T7 may be implemented as PMOS transistors, and the fifth and sixth transistors T5 and T6 may be implemented as NMOS transistors. In one or more other embodiments, one or more of the first to seventh transistors T1, T2, T3, T4, T5, T6, and T7 may be an NMOS transistor(s), and one or more others may be a PMOS transistor(s). That is, embodiments of the disclosure are not limited to a type of a transistor.

An oxide thin film transistor may be a low temperature polycrystalline oxide (LTPO) thin film transistor in which an active pattern (semiconductor layer) includes oxide. However, this is only example, and the N-type transistors are not limited thereto. For example, the active pattern (semiconductor layer) included in the N-type transistor may include an inorganic semiconductor (for example, amorphous silicon or poly silicon), an organic semiconductor, or the like. The silicon thin film transistor may be a low temperature poly-silicon (LTPS) thin film transistor in which an active pattern (semiconductor layer) includes amorphous silicon, poly silicon, or the like.

In a case of the NMOS transistor, a low voltage level may be a deactivation level, and a high voltage level may be an activation level. For example, when a signal applied to a control electrode of the NMOS transistor has the low voltage level, the NMOS transistor may be turned off. For example, when the signal applied to the control electrode of the NMOS transistor has the high voltage level, the NMOS transistor may be turned on.

In a case of the PMOS transistor, the low voltage level may be an activation level, and the high voltage level may be a deactivation level. For example, when a signal applied to a control electrode of the PMOS transistor has the low voltage level, the PMOS transistor may be turned on. For example, when the signal applied to the control electrode of the PMOS transistor has the high voltage level, the PMOS transistor may be turned off. That is, the activation level and deactivation level may be determined according to a type of a transistor.

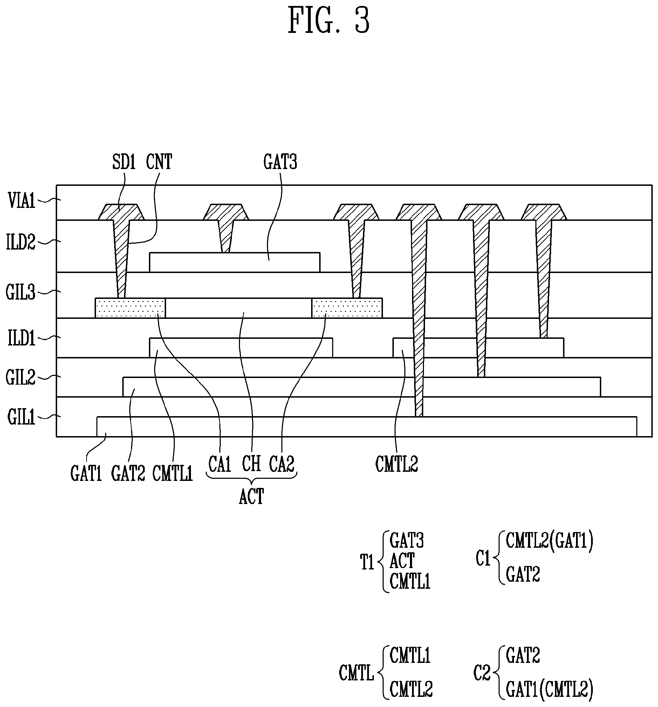

FIG. 3 is a cross-sectional view illustrating an example of the first transistor and the first and second capacitors of FIG. 2.

Referring to FIGS. 2 and 3, the pixel P may include a first electrode layer GAT1, a first gate-insulating layer GIL1, a second electrode layer GAT2, a second gate-insulating layer GIL2, an additional electrode layer CMTL, a first interlayer insulating layer ILD1, an active layer ACT, a third gate-insulating layer GIL3, a third electrode layer GAT3, a second interlayer insulating layer ILD2, a connection electrode layer SD1, and a via layer VIA1.

In one or more embodiments, the first electrode layer GAT1 may form the second electrode of the second capacitor C2. For example, the first electrode layer GAT1 may be formed as a conductive pattern including at least one material among copper (Cu), molybdenum (Mo), tungsten (W), aluminum neodymium (AINd), titanium (Ti), aluminum (Al), and silver (Ag).

In one or more other embodiments, the first electrode layer GAT1 may form the first electrode of the first capacitor C1. In this case, the first electrode layer GAT1 may be electrically connected to the third electrode layer GAT3. For example, the connection electrode layer SD1 that is connected to the first electrode layer GAT1 through a contact hole CNT may be connected to the connection electrode layer SD1 that is connected to the third electrode layer GAT3 through a contact hole CNT. For example, the connection electrode layer SD1 connected to the first electrode layer GAT1 through the contact hole CNT and the connection electrode layer SD1 connected to the third electrode layer GAT3 through the contact hole CNT may form one conductive pattern. For example, a conductive pattern forming the connection electrode layer SD1 connected to the first electrode layer GAT1 through the contact hole CNT and the conductive pattern forming the connection electrode layer SD1 connected to the third electrode layer GAT3 through the contact hole CNT may be connected in another layer through a via hole passing through the via layer VIA1.

The first gate-insulating layer GIL1 may be located on the first electrode layer GAT1 (as used herein, "located on" may mean "above"). The first gate-insulating layer GIL1 may be an inorganic insulating layer including an inorganic material. For example, the first gate-insulating layer GIL1 may include at least one of metal oxides, such as silicon nitride (SiNₓ), silicon oxide (SiOₓ), silicon oxynitride (SiOₓN_{y}), or aluminum oxide (AlOₓ). However, the first gate-insulating layer GIL1 is not limited thereto. For example, the first gate-insulating layer GIL1 may include an organic insulating layer including an organic material.

The first gate-insulating layer GIL1 may electrically isolate conductive patterns and/or semiconductor patterns located with the first gate-insulating layer GIL1 interposed therebetween. For example, the first gate-insulating layer GIL1 may be located between the first electrode layer GAT1 and the second electrode layer GAT2 so that the first electrode layer GAT1 is spaced apart from the second electrode layer GAT2. In embodiments, the first gate-insulating layer GIL1 may cover the first electrode layer GAT1.

The second electrode layer GAT2 is located on the first gate-insulating layer GIL1. The second electrode layer GAT2 may form the first electrode of the second capacitor C2 and the second electrode of the first capacitor C1. For example, the first electrode layer GAT1 may be formed as a conductive pattern including at least one material among copper (Cu), molybdenum (Mo), tungsten (W), aluminum neodymium (AINd), titanium (Ti), aluminum (Al), and silver (Ag).

In one or more embodiments, a width of the second electrode layer GAT2 may be narrower than a width of the first electrode layer GAT1. Accordingly, even though a position of the second electrode layer GAT2 is slightly misaligned in a process of forming the second electrode layer GAT2, a capacitance of the first capacitor C1 or the second capacitor C2 may be maintained.

As described above, the first capacitor C1 and the second capacitor C2 may be connected in series by sharing the second electrode layer GAT2. Accordingly, the area occupied by the pixel P is reduced, and implementation of high resolution is possible.

The second gate-insulating layer GIL2 may be located on the first gate-insulating layer GIL1 and the second electrode layer GAT2. The second gate-insulating layer GIL2 may be an inorganic insulating layer including an inorganic material. For example, the second gate-insulating layer GIL2 may include at least one of metal oxides, such as silicon nitride (SiNₓ), silicon oxide (SiOₓ), silicon oxynitride (SiOₓN_{y}), or aluminum oxide (AlOₓ). However, the second gate-insulating layer GIL2 is not limited thereto. For example, the second gate-insulating layer GIL2 may include an organic insulating layer including an organic material.

The second gate-insulating layer GIL2 may electrically isolate conductive patterns and/or semiconductor patterns located with the second gate-insulating layer GIL2 interposed therebetween. For example, the second gate-insulating layer GIL2 may be located between the additional electrode layer CMTL and the second electrode layer GAT2 so that the additional electrode layer CMTL is spaced apart from the second electrode layer GAT2. In embodiments, the second gate-insulating layer GIL2 may be entirely provided on the second electrode layer GAT2 and the first gate-insulating layer GIL1 to cover the second electrode layer GAT2 and the first gate-insulating layer GIL1.

The first transistor T1 may be located on the second gate-insulating layer GIL2. The first transistor T1 may include a first electrode pattern CMTL1 of the additional electrode layer CMTL, the active layer ACT, and the third electrode layer GAT3.

The additional electrode layer CMTL may include the first electrode pattern CMTL1 and a second electrode pattern CMTL2. The additional electrode layer CMTL is located on the second gate-insulating layer GIL2. For example, the additional electrode layer CMTL may be formed as a conductive pattern including at least one material among copper (Cu), molybdenum (Mo), tungsten (W), aluminum neodymium (AINd), titanium (Ti), aluminum (Al), and silver (Ag).

The first electrode pattern CMTL1 may form the back gate electrode of the first transistor T1. For example, at least a portion of the first electrode pattern CMTL1 may overlap a channel area CH of the active layer ACT. The first electrode pattern CMTL1 may also be connected to another electrode through the connection electrode layer SD1.

In one or more embodiments, the second electrode pattern CMTL2 may form the first electrode of the first capacitor C1. In this case, the second electrode pattern CMTL2 may be electrically connected to the third electrode layer GAT3. For example, the connection electrode layer SD1 connected to the second electrode pattern CMTL2 through the contact hole CNT may be connected to the connection electrode layer SD1 connected to the third electrode layer GAT3 through the contact hole CNT. For example, the connection electrode layer SD1 connected to the second electrode pattern CMTL2 through the contact hole CNT and the connection electrode layer SD1 connected to the third electrode layer GAT3 through the contact hole CNT may form a single conductive pattern. For example, a conductive pattern forming the connection electrode layer SD1 connected to the second electrode pattern CMTL2 through the contact hole CNT, and a conductive pattern forming the connection electrode layer SD1 connected to the third electrode layer GAT3 through the contact hole CNT, may be connected in different layers through a via hole passing through the via layer VIA1.

In one or more other embodiments, the second electrode pattern CMTL2 may form the second electrode of the second capacitor C2. For example, the second electrode pattern CMTL2 may be electrically connected to the light-emitting element LD.

In one or more embodiments, a width of the second electrode pattern CMTL2 may be narrower than a width of the second electrode layer GAT2. Accordingly, even though a position of the second electrode pattern CMTL2 is slightly misaligned in a process of forming the second electrode pattern CMTL2, the capacitance of the first capacitor C1 or the second capacitor C2 may be maintained.

The first interlayer insulating layer ILD1 may be located on the second gate-insulating layer GIL2 and the additional electrode layer CMTL. The first interlayer insulating layer ILD1 may be an inorganic insulating layer including an inorganic material. For example, the first interlayer insulating layer ILD1 may include at least one of metal oxides, such as silicon nitride (SiNₓ), silicon oxide (SiOₓ), silicon oxynitride (SiOₓN_{y}), or aluminum oxide (AlOₓ). However, the first interlayer insulating layer ILD1 is not limited thereto. For example, the first interlayer insulating layer ILD1 may include an organic insulating layer including an organic material.

The first interlayer insulating layer ILD1 may electrically isolate conductive patterns and/or semiconductor patterns located with the first interlayer insulating layer ILD1 interposed therebetween. For example, the first interlayer insulating layer ILD1 may be located between the additional electrode layer CMTL and the active layer ACT so that the additional electrode layer CMTL is spaced apart from the active layer ACT. In embodiments, the first interlayer insulating layer ILD1 may be entirely provided on the additional electrode layer CMTL and the second gate-insulating layer GIL2 to cover the additional electrode layer CMTL and the second gate-insulating layer GIL2.

The active layer ACT may be located on the first interlayer insulating layer ILD1. The active layer ACT may include one of various types of semiconductors, for example, an amorphous silicon semiconductor, a monocrystalline silicon semiconductor, a polycrystalline silicon semiconductor, a low temperature poly silicon semiconductor, and an oxide semiconductor.

The active layer ACT may form the channel area CH of the first transistor T1. The active layer ACT may include a first contact area CA1 and a second contact area CA2 connected to the connection electrode layer SD1. The first contact area CA1 and the second contact area CA2 may be connected to the connection electrode layer SD1 through a contact hole CNT.

An area between the first contact area CA1 and the second contact area CA2 may be the channel area CH. The channel area CH may overlap the third electrode layer GAT3 forming the control electrode of the first transistor T1. The channel area CH may be a semiconductor pattern that is not doped with an impurity and may be an intrinsic semiconductor. The first contact area CA1 and the second contact area CA2 may be a semiconductor pattern doped with an impurity.

The third gate-insulating layer GIL3 may be located on the first interlayer insulating layer ILD1 and the active layer ACT. The third gate-insulating layer GIL3 may be an inorganic insulating layer including an inorganic material. For example, the third gate-insulating layer GIL3 may include at least one of metal oxides, such as silicon nitride (SiNₓ), silicon oxide (SiOₓ), silicon oxynitride (SiOₓN_{y}), or aluminum oxide (AlOₓ). However, the third gate-insulating layer GIL3 is not limited thereto. For example, the third gate-insulating layer GIL3 may include an organic insulating layer including an organic material.

The third gate-insulating layer GIL3 may electrically isolate conductive patterns and/or semiconductor patterns located with the third gate-insulating layer GIL3 interposed therebetween. For example, the third gate-insulating layer GIL3 may be located between the active layer ACT and the third electrode layer GAT3 so that the active layer ACT is spaced apart from the third electrode layer GAT3. In embodiments, the third gate-insulating layer GIL3 may be entirely provided on the active layer ACT and the first interlayer insulating layer ILD1 to cover the active layer ACT and the first interlayer insulating layer ILD1.

The third electrode layer GAT3 is located on the third gate-insulating layer GIL3. The third electrode layer GAT3 may form the control electrode of the first transistor T1. The third electrode layer GAT3 may overlap the channel area CH of the active layer ACT. For example, the third electrode layer GAT3 may be formed as a conductive pattern including at least one material among copper (Cu), molybdenum (Mo), tungsten (W), aluminum neodymium (AINd), titanium (Ti), aluminum (Al), and silver (Ag).

The second interlayer insulating layer ILD2 may be located on the third gate-insulating layer GIL3 and the third electrode layer GAT3. The second interlayer insulating layer ILD2 may be an inorganic insulating layer including an inorganic material. For example, the second interlayer insulating layer ILD2 may include at least one of metal oxides, such as silicon nitride (SiNₓ), silicon oxide (SiOₓ), silicon oxynitride (SiOₓN_{y}), or aluminum oxide (AlOₓ). However, the second interlayer insulating layer ILD2 is not limited thereto. For example, the second interlayer insulating layer ILD2 may include an organic insulating layer including an organic material.

The second interlayer insulating layer ILD2 may electrically isolate conductive patterns and/or semiconductor patterns located with the second interlayer insulating layer ILD2 interposed therebetween. For example, the second interlayer insulating layer ILD2 may be located between the third electrode layer GAT3 and the connection electrode layer SD1 so that the third electrode layer GAT3 is spaced apart from the connection electrode layer SD1. In embodiments, the second interlayer insulating layer ILD2 may be entirely provided on the third gate-insulating layer GIL3 and the third electrode layer GAT3 to cover the third gate-insulating layer GIL3 and the third electrode layer GAT3.

The connection electrode layer SD1 is located on the second interlayer insulating layers ILD2. The connection electrode layer SD1 may be connected to the active layer ACT, the first to third electrode layers GAT1, GAT2, and GAT3, and the additional electrode layer CMTL through the contact hole CNT. For example, the connection electrode layer SD1 may be formed as a conductive pattern including at least one material among copper (Cu), molybdenum (Mo), tungsten (W), aluminum neodymium (AINd), titanium (Ti), aluminum (Al), and silver (Ag).

The via layer VIA1 may be located on the connection electrode layer SD1. One via layer VIA1 and one connection electrode layer SD1 are shown as an example, but embodiments of the disclosure are not limited to the number of via layers and connection electrode layers. When the number of connection electrode layers is plural, respective via layers may electrically isolate the connection electrode layers from each other.

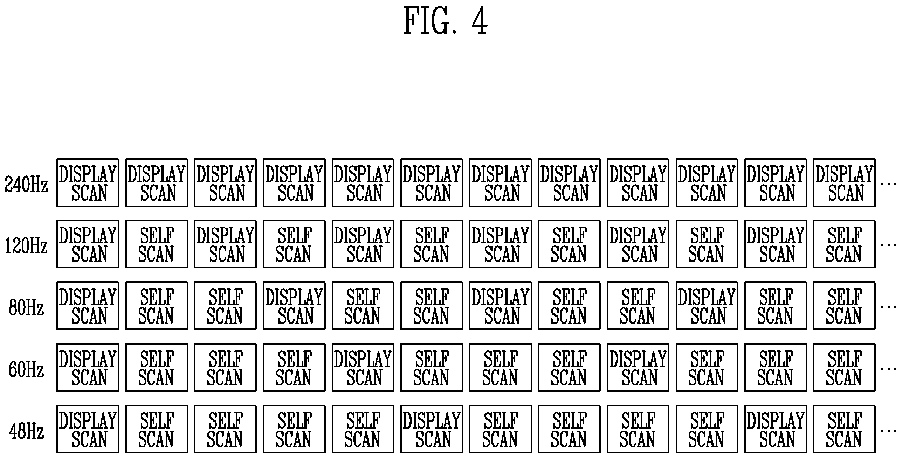

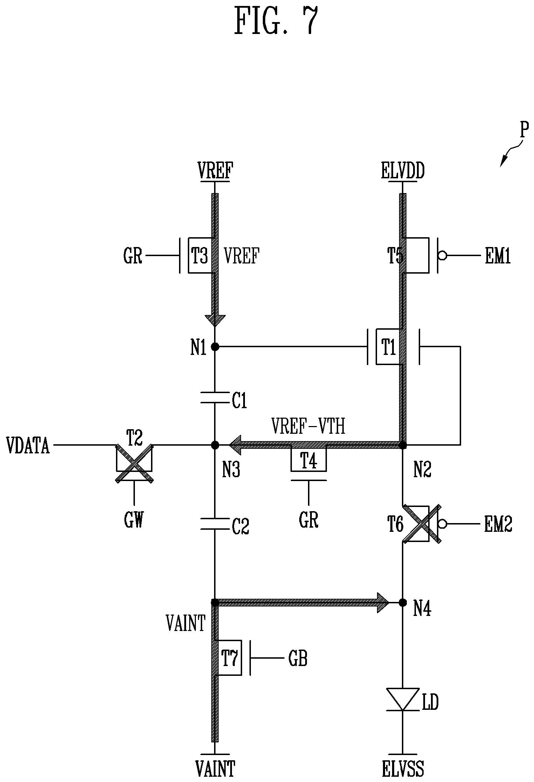

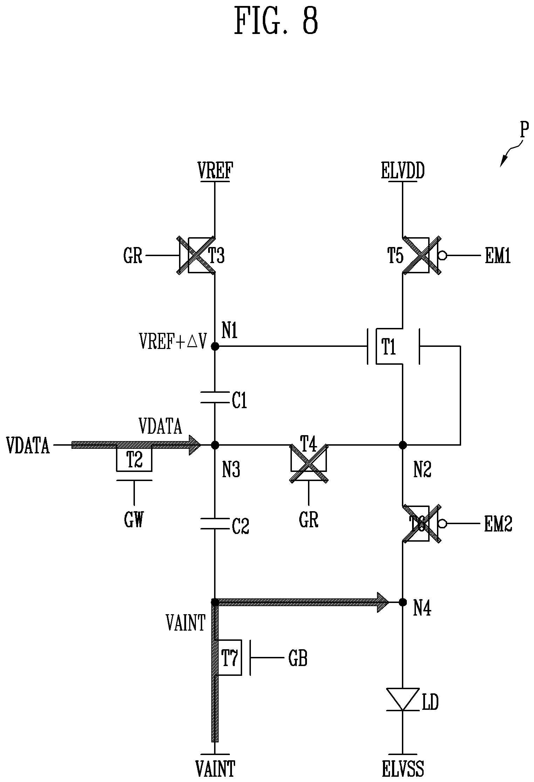

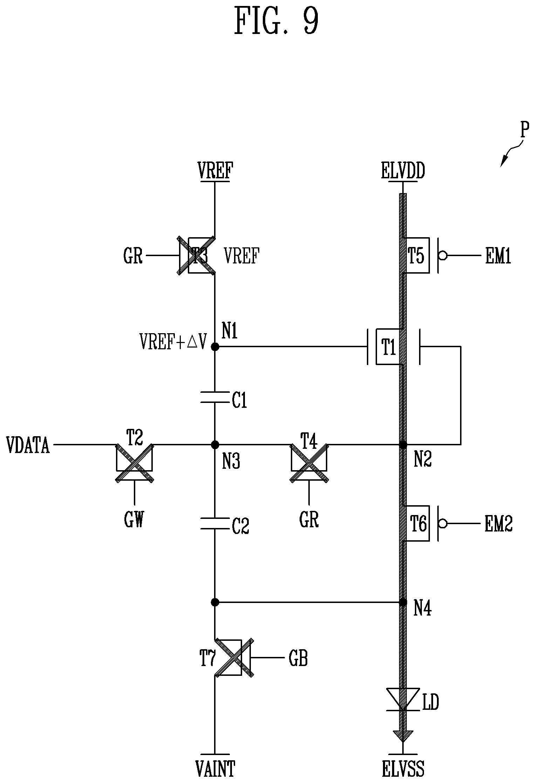

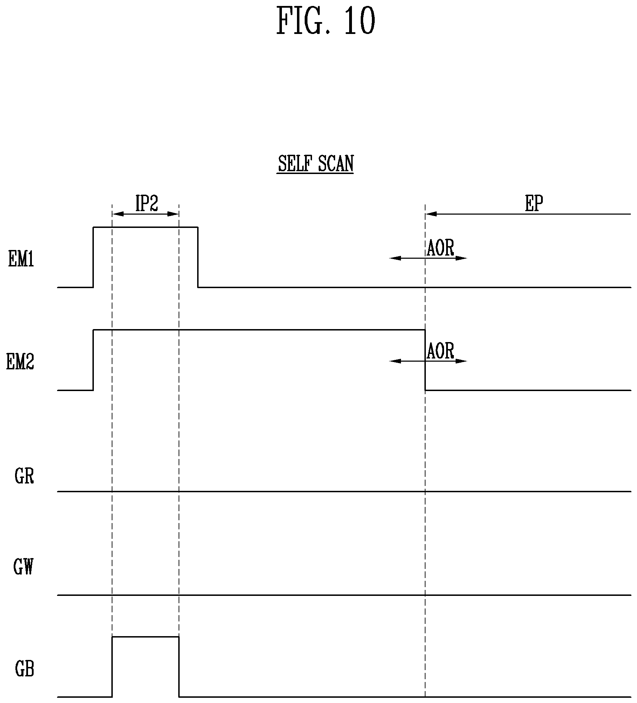

FIG. 4 is a conceptual diagram illustrating a driving operation of the display device of FIG. 1, FIGS. 5 to 9 are drawings illustrating an example in which the display device of FIG. 1 performs a display scan operation, and FIG. 10 is a timing diagram illustrating an example in which the display device of FIG. 1 performs a self-scan operation.

Referring to FIGS. 1, 2, and 4, a display scan operation DISPLAY SCAN or a self-scan operation SELF SCAN may be performed in one frame. When the display scan operation DISPLAY SCAN is performed, a write operation of a data voltage VDATA may be performed, and when the self-scan operation SELF SCAN is performed, a light-emitting operation may be performed without writing the data voltage V DATA.

At a maximum driving frequency of the display panel 100 (for example, when a driving frequency is about 240 Hz), the display scan operation DISPLAY SCAN of one frame may be successively repeated, and the display scan operation DISPLAY SCAN of one frame may be one driving frame.

At driving frequencies (that is, about 120 Hz, about 80 Hz, about 60 Hz, and about 48 Hz) excluding the maximum driving frequency of the display panel 100 (that is, if it is assumed that the maximum driving frequency is about 240 Hz in FIG. 4), the display scan operation DISPLAY SCAN may be performed in one frame and the self-scan operation SELF SCAN may be performed in at least one frame.

For example, when the driving frequency is about 120 Hz, the display scan operation DISPLAY SCAN of one frame and the self-scan operation SELF SCAN of one frame may be repeated, and the display scan operation DISPLAY SCAN of one frame and the self-scan operation SELF SCAN of one frame may configure one driving frame (that is, the same image may be displayed during one driving frame). When the driving frequency is about 80 Hz, the display scan operation DISPLAY SCAN of one frame and the self-scan operation SELF SCAN of two frames may be repeated, and the display scan operation DISPLAY SCAN of one frame and the self-scan operation SELF SCAN of two frames may configure one driving frame. When the driving frequency is about 60 Hz, the display scan operation DISPLAY SCAN of one frame and the self-scan operation SELF SCAN of three frames may be repeated, and the display scan operation DISPLAY SCAN of one frame and the self-scan operation SELF SCAN of three frames may configure one driving frame. When the driving frequency is about 48 Hz, the display scan operation DISPLAY SCAN of one frame and the self-scan operation SELF SCAN of four frames may be repeated, and the display scan operation DISPLAY SCAN of one frame and the self-scan operation SELF SCAN of four frames may configure one driving frame.

As described above, the driving controller 200 may vary the driving frequency by adjusting a length of the self-scan operation SELF SCAN.

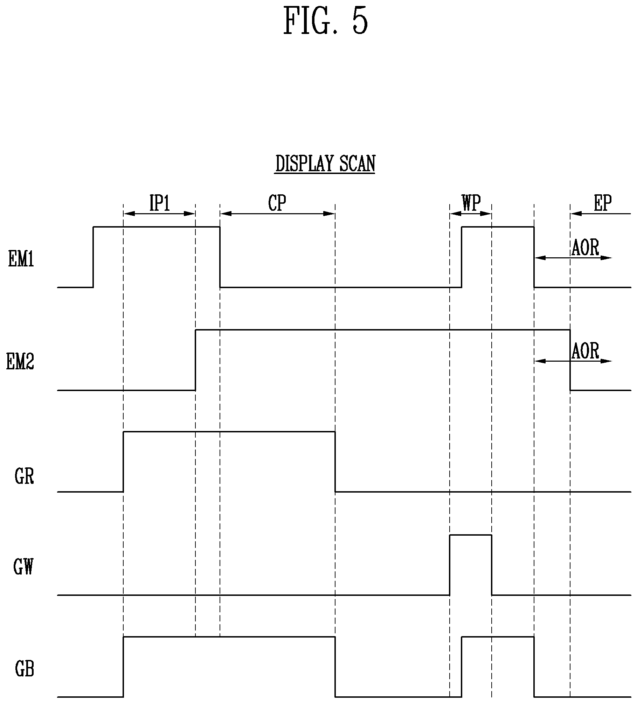

Referring to FIG. 2 and FIG. 5, the data voltage VDATA may be written in a frame in which the display scan operation DISPLAY SCAN is performed. A frame in which the display scan operation DISPLAY SCAN is performed may include a first initialization period IP1, a compensation period CP, a writing period WP, and an emission period EP.

Referring to FIGS. 2, 5, and 6, in the first initialization period IP1, the second emission signal EM2, the reference gate signal GR, and the bias gate signal GB may have the activation level, and the third, sixth, and seventh transistors T3, T6, and T7 may be turned on. Accordingly, the reference voltage VREF may be applied to the first node N1, and the initialization voltage VAINT may be applied to the third node N3 and the fourth node N4. Therefore, the first capacitor C1 and the second capacitor C2 may be initialized.

Referring to FIGS. 2, 5, and 7, in the compensation period CP, the first emission signal EM1, the reference gate signal GR, and the bias gate signal GB have the activation level, and the third to fifth and seventh transistors T3 to T5, and T7 may be turned on. Accordingly, the reference voltage VREF may be applied to the first node N1, a voltage of the second node N2 may be increased by a voltage obtained by subtracting a threshold voltage VTH of the first transistor T1 from a voltage of the first node N1, and the initialization voltage VAINT may be applied to the fourth node N4. In addition, the voltage of the second node N2 may be transmitted to the third node N3.

Referring to FIGS. 2, 5, and 8, in the write period WP, the write gate signal GW and the bias gate signal GB may have the activation level, and the second and seventh transistors T2 and T7 may be turned on. Accordingly, the data voltage VDATA may be applied to the third node N3, and the initialization voltage VAINT may be applied to the fourth node N4. In addition, the voltage of the first node N1 may change by a voltage change amount ΔV of the third node N3 by coupling of the first capacitor C1. Therefore, the data voltage VDATA may be written to the first capacitor C1.

The first emission signal EM1 may have the activation level after the write gate signal GW has the activation level, but embodiments of the disclosure are not limited thereto. For example, the write gate signal GW and the first emission signal EM1 may concurrently or simultaneously have the activation level.

Referring to FIGS. 2, 5, and 9, in the emission period EP, the first emission signal EM1 and the second emission signal EM2 may have the activation level, and the fifth and sixth transistors T5 and T6 may be turned on. Accordingly, the first power voltage ELVDD may be applied to the first transistor T1, and the first transistor T1 may generate a driving current corresponding to the voltage of the first node N1. The light-emitting element LD may emit light with a luminance corresponding to the driving current.

Because the first capacitor C1 to which the data voltage VDATA is written is not directly connected to the second electrode of the first transistor T1, influence on the voltage written to the first capacitor C1 due to the driving current may be reduced or minimized, and an error of threshold voltage compensation may be reduced.

Referring to FIGS. 2 and 10, a frame performing the self-scan operation SELF SCAN may include a second initialization period IP2 and an emission period EP. Because the emission period EP is substantially the same as the frame in which the display scan operation DISPLAY SCAN (refer to FIG. 5) is performed, an overlapping description is omitted.

In the second initialization period IP2, the bias gate signal GB may have the activation level, and the seventh transistor T7 may be turned on. Accordingly, the initialization voltage VAINT may be applied to the fourth node N4. Therefore, the anode electrode of the light-emitting element LD may be initialized.

Referring to FIGS. 2, 5, and 10, the driving controller 200 (refer to FIG. 1) may adjust an off duty ratio of at least one of the first emission signal EM1 and the second emission signal EM2 according to an emission off ratio AOR. For example, the driving controller 200 (refer to FIG. 1) may adjust the off duty ratio of the first emission signal EM1 according to the emission off ratio AOR. In this case, in the frame in which the self-scan operation SELF SCAN is performed, the off duty ratio of the first emission signal EM1 may be adjusted by applying the first emission signal EM1 having the deactivation level in the emission period EP. For example, the driving controller 200 (refer to FIG. 1) may adjust the off duty ratio of the second emission signal EM2 according to the emission off ratio AOR. For example, the driving controller 200 (refer to FIG. 1) may adjust the off duty ratio of the first emission signal EM1 and the second emission signal EM2 according to the emission off ratio AOR. Here, the emission off ratio AOR means a ratio of a time in which the light-emitting element LD emits light in one frame, and the off duty ratio means a ratio of a period having a deactivation level in one frame.

When both of the first emission signal EM1 and the second emission signal EM2 do not have the activation level, the light-emitting element LD does not emit light. Therefore, the driving controller 200 may adjust the emission off ratio AOR by adjusting the off duty ratio of at least one of the first emission signal EM1 and the second emission signal EM2.

The emission off ratio AOR may be adjusted by adjusting only the off duty ratio of the second emission signal EM2, but the emission off ratio AOR may be adjusted by adjusting only the off duty ratio of the first emission signal EM1.

In one or more embodiments, the emission off ratio AOR may be a value set by a user. In one or more other embodiments, the emission off ratio AOR may be a value that is automatically determined according to a set value when the user determines the set value, such as a brightness or a maximum luminance of a screen.

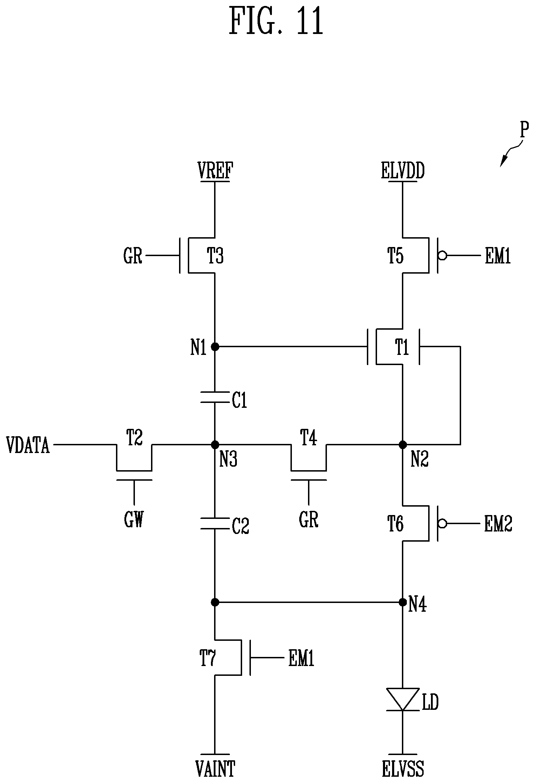

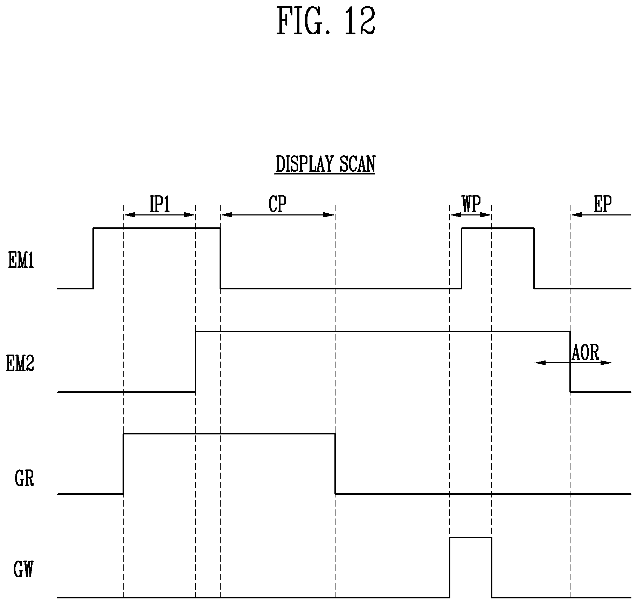

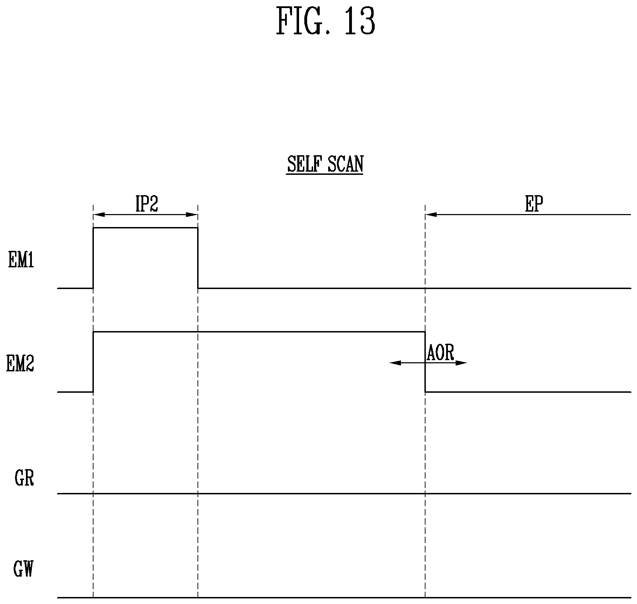

FIG. 11 is a circuit diagram illustrating a pixel of a display device according to embodiments of the disclosure, FIG. 12 is a timing diagram illustrating an example in which the display device of FIG. 11 performs a display scan operation, and FIG. 13 is a timing diagram illustrating an example in which the display device of FIG. 11 performs a self-scan operation.

Because the display device according to the present embodiments is substantially the same as a configuration of the display device of FIG. 1, except that the first emission signal EM1 is applied to the control electrode of the seventh transistor T7, the same reference numbers and reference symbols are used for the same or similar components, and an overlapping description is omitted.

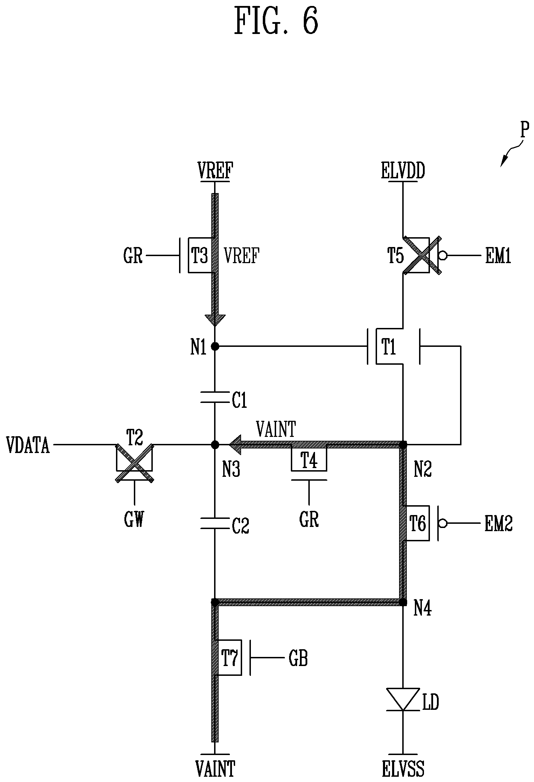

Referring to FIGS. 11 to 13, the pixel P may include a seventh transistor T7 including a control electrode for receiving the first emission signal EM1, a first electrode for receiving the initialization voltage VAINT, and a second electrode connected to the fourth node N4. The seventh transistor T7 may be a type different from that of the fifth transistor T5. For example, as shown in FIG. 6, when the seventh transistor T7 is an NMOS transistor, the fifth transistor T5 may be a PMOS transistor. That is, when the seventh transistor T7 is turned on, the fifth transistor T5 may be turned off, and when the seventh transistor T7 is turned off, the fifth transistor T5 may be turned on. As described above, by controlling the seventh transistor T7 through the first emission signal EM1, a used line may be reduced, and implementation of high resolution is possible.

Because the display scan operation DISPLAY SCAN and the self-scan operation SELF SCAN are substantially the same as the embodiments described with reference to FIGS. 5 to 10, an overlapping description is omitted.

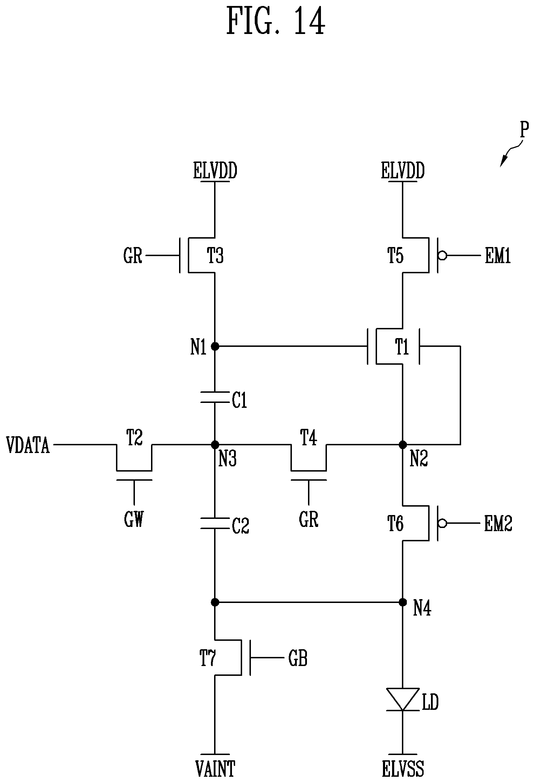

FIG. 14 is a circuit diagram illustrating a pixel of a display device according to embodiments of the disclosure.

Because the display device according to the present embodiments is substantially the same as the configuration of the display device of FIG. 1, except that the first power voltage ELVDD is applied to the first electrode of the third transistor T3, the same reference numbers and reference symbols are used for the same or similar components, and an overlapping description is omitted.

Referring to FIG. 14, the pixel P may include a third transistor T3 including a control electrode for receiving the reference gate signal GR, a first electrode for receiving the first power voltage ELVDD, and a second electrode connected to the first node N1.

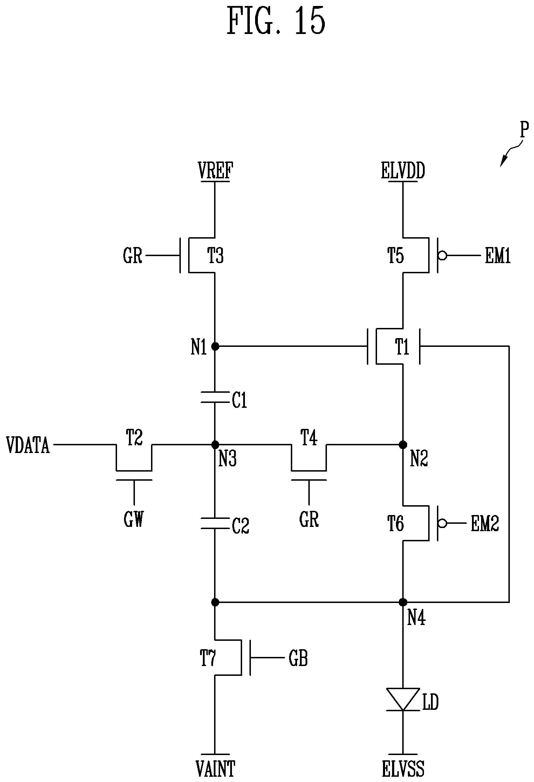

FIG. 15 is a circuit diagram illustrating a pixel of the display device according to embodiments of the disclosure.

Because the display device according to the present embodiments is substantially the same as the configuration of the display device of FIG. 1, except that the back gate electrode of the first transistor T1 is connected to the fourth node N4, the same reference numbers and reference symbols are used for the same or similar components, and an overlapping description is omitted.

Referring to FIG. 15, the pixel P may include a first transistor T1 including a control electrode connected to the first node N1, a first electrode connected to the second electrode of the fifth transistor T5, a second electrode connected to the second node N2, and the back gate electrode connected to the light-emitting element LD. For example, the back gate electrode of the first transistor T1 may be connected to the anode electrode of the light-emitting element LD.

At least two of the one or more embodiments corresponding to FIGS. 11, 14, and 15 may be combined to configure one or more other embodiments.

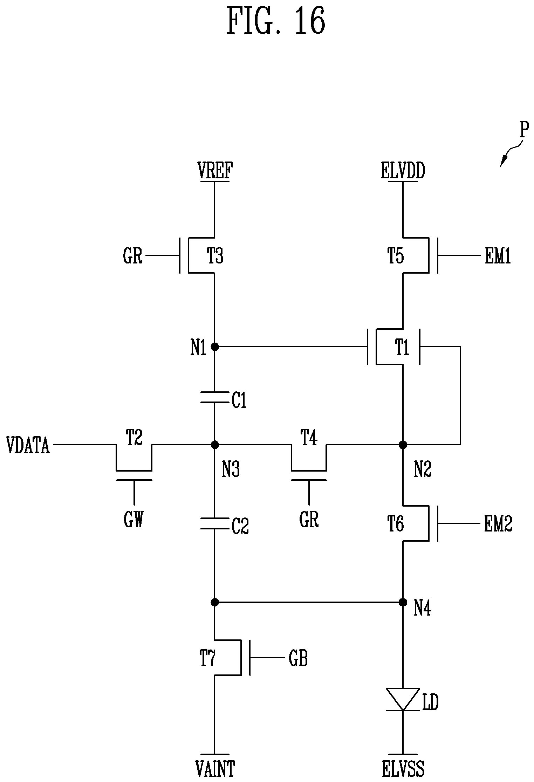

FIG. 16 is a circuit diagram illustrating a pixel of a display device according to embodiments of the disclosure.

Because the circuit diagram according to the present embodiments is substantially the same as a configuration of the circuit diagram of FIG. 2, except that the fifth and sixth transistors T5 and T6 are NMOS transistors, the same reference numbers and reference symbols are used for the same or similar components, and an overlapping description is omitted.

Referring to FIG. 16, the first to seventh transistors T1 to T7 may be implemented as NMOS transistors. In this case, the first and second emission signals EM1 and EM2 applied to the pixel P of FIG. 16 may be opposite to the first and second emission signals EM1 and EM2 applied to the pixel P of FIG. 2. For example, at a timing when the first and second emission signals EM1 and EM2 applied to the pixel P of FIG. 2 have a high voltage level, the first and second emission signals EM1 and EM2 applied to the pixel P of FIG. 16 may have a low voltage level. Similarly at a timing when the first and second emission signals EM1 and EM2 applied to the pixel P of FIG. 2 have a low voltage level, the first and second emission signals EM1 and EM2 applied to the pixel P of FIG. 16 may have a high voltage level.

In one or more embodiments, at least one of the first to seventh transistors T1 to T7 may include an oxide semiconductor. For example, at least one of the first to seventh transistors T1 to T7 may be an oxide semiconductor transistor including an oxide semiconductor.

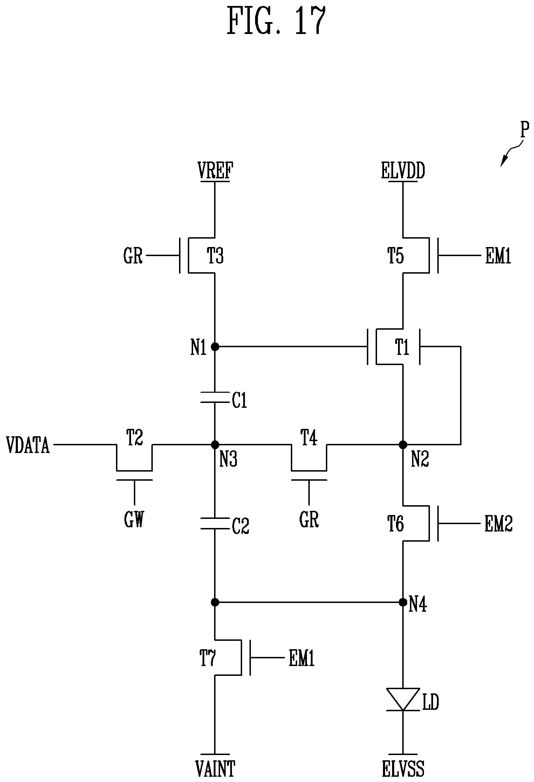

FIG. 17 is a circuit diagram illustrating a pixel of a display device according to embodiments of the disclosure.

Because the circuit diagram according to the present embodiments is substantially the same as a configuration of the circuit diagram of FIG. 11, except that the fifth and sixth transistors T5 and T6 are NMOS transistors, the same reference numbers and reference symbols are used for the same or similar components, and an overlapping description is omitted.

Referring to FIG. 17, the first to seventh transistors T1 to T7 may be implemented as NMOS transistors. In this case, the first and second emission signals EM1 and EM2 applied to the pixel P of FIG. 17 may be opposite to the first and second emission signals EM1 and EM2 applied to the pixel P of FIG. 11. For example, at a timing when the first and second emission signals EM1 and EM2 applied to the pixel P of FIG. 11 have a high voltage level, the first and second emission signals EM1 and EM2 applied to the pixel P of FIG. 17 may have a low voltage level. Similarly, at a timing when the first and second emission signals EM1 and EM2 applied to the pixel P of FIG. 11 have a low voltage level, the first and second emission signals EM1 and EM2 applied to the pixel P of FIG. 17 may have a high voltage level.

In one or more embodiments, at least one of the first to seventh transistors T1 to T7 may include an oxide semiconductor. For example, at least one of the first to seventh transistors T1 to T7 may be an oxide semiconductor transistor including an oxide semiconductor.

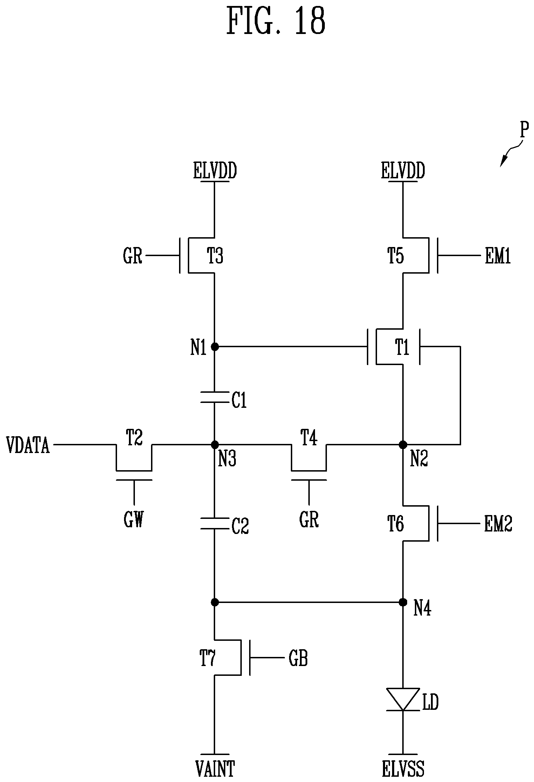

FIG. 18 is a circuit diagram illustrating a pixel of a display device according to embodiments of the disclosure.

Because the circuit diagram according to the present embodiments is substantially the same as a configuration of the circuit diagram of FIG. 14, except that the fifth and sixth transistors T5 and T6 are NMOS transistors, the same reference numbers and reference symbols are used for the same or similar components, and an overlapping description is omitted.

Referring to FIG. 18, the first to seventh transistors T1 to T7 may be implemented as NMOS transistors. In this case, the first and second emission signals EM1 and EM2 applied to the pixel P of FIG. 18 may be opposite to the first and second emission signals EM1 and EM2 applied to the pixel P of FIG. 14. For example, at a timing when the first and second emission signals EM1 and EM2 applied to the pixel P of FIG. 14 have a high voltage level, the first and second emission signals EM1 and EM2 applied to the pixel P of FIG. 18 may have a low voltage level. Similarly, at a timing when the first and second emission signals EM1 and EM2 applied to the pixel P of FIG. 14 have a low voltage level, the first and second emission signals EM1 and EM2 applied to the pixel P of FIG. 18 may have a high voltage level.

In one or more embodiments, at least one of the first to seventh transistors T1 to T7 may include an oxide semiconductor. For example, at least one of the first to seventh transistors T1 to T7 may be an oxide semiconductor transistor including an oxide semiconductor.

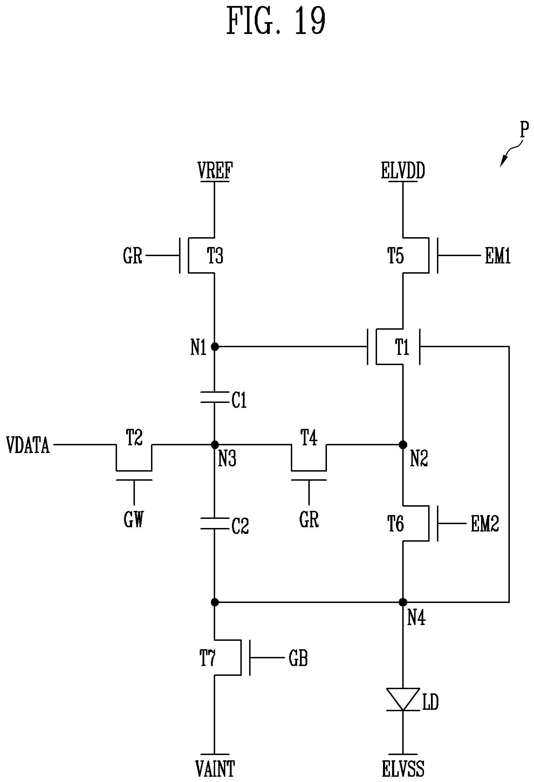

FIG. 19 is a circuit diagram illustrating a pixel of a display device according to embodiments of the disclosure.

Because the circuit diagram according to the present embodiments is substantially the same as a configuration of the circuit diagram of FIG. 15, except that the fifth and sixth transistors T5 and T6 are NMOS transistors, the same reference numbers and reference symbols are used for the same or similar components, and an overlapping description is omitted.

Referring to FIG. 19, the first to seventh transistors T1 to T7 may be implemented as NMOS transistors. In this case, the first and second emission signals EM1 and EM2 applied to the pixel P of FIG. 19 may be opposite to the first and second emission signals EM1 and EM2 applied to the pixel P of FIG. 15. For example, at a timing when the first and second emission signals EM1 and EM2 applied to the pixel P of FIG. 15 have a high voltage level, the first and second emission signals EM1 and EM2 applied to the pixel P of FIG. 19 may have a low voltage level. Similarly, at a timing when the first and second emission signals EM1 and EM2 applied to the pixel P of FIG. 15 have a low voltage level, the first and second emission signals EM1 and EM2 applied to the pixel P of FIG. 19 may have a high voltage level.

In one or more embodiments, at least one of the first to seventh transistors T1 to T7 may include an oxide semiconductor. For example, at least one of the first to seventh transistors T1 to T7 may be an oxide semiconductor transistor including an oxide semiconductor.

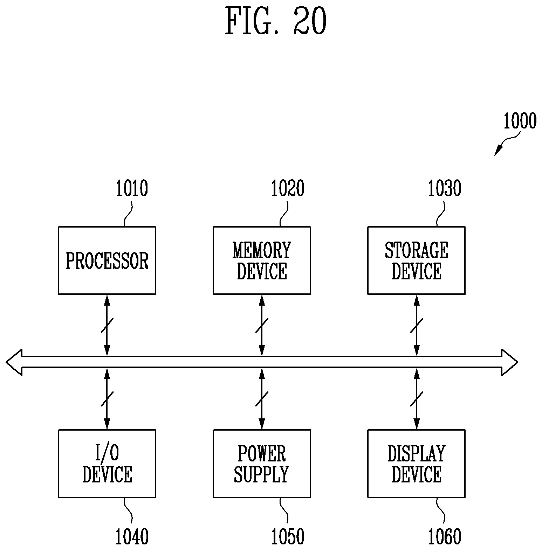

FIG. 20 is a block diagram illustrating an electronic device according to embodiments of the disclosure.

Referring to FIG. 20, the electronic device 1000 may include a processor 1010, a memory device 1020, a storage device 1030, an input/output device (I/O device) 1040, a power supply 1050, and a display device 1060. At this time, the display device 1060 may be the display device of FIG. 1. In addition, the electronic device 1000 may further include several ports capable of communicating with a video card, a sound card, a memory card, a USB device, or the like, or communicating with other systems. In one or more embodiments, the electronic device 1000 may be implemented as a smart phone. However, this is only an example, and the electronic device 1000 is not limited thereto. For example, the electronic device 1000 may be implemented as a mobile phone, a television, a video phone, a smart pad, a smart watch, a tablet PC, a vehicle navigation device, a computer monitor, a notebook computer, a head mounted display device, or the like.

The processor 1010 may perform specific calculations or tasks. According to one or more embodiments, the processor 1010 may be a microprocessor, a central processing unit, an application processor, or the like. The processor 1010 may be connected to other components through an address bus, a control bus, a data bus, or the like. According to one or more embodiments, the processor 1010 may also be connected to an expansion bus, such as a peripheral component interconnect (PCI) bus.

The memory device 1020 may store data suitable for an operation of the electronic device 1000. For example, the memory device 1020 may include a nonvolatile memory device, such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, and a ferroelectric random access memory (FRAM) device, a volatile memory device, such as a dynamic random access memory (DRAM) device, a static random access memory (SRAM) device, and a mobile DRAM device, and/or the like.

The storage device 1030 may include a solid state drive (SSD), a hard disk drive (HDD), a CD-ROM, and the like.

The input/output device 1040 may include an input means, such as a keyboard, a keypad, a touch pad, a touch screen, and a mouse, and an output means, such as a speaker and a printer. According to one or more embodiments, the display device 1060 may be included in the input/output device 1040.

The power supply 1050 may supply power suitable for an operation of the electronic device 1000. For example, the power supply 1050 may be a power management integrated circuit (PMIC).

The display device 1060 may display an image corresponding to visual information of the electronic device 1000. At this time, the display device 1060 may be an organic light-emitting display device or a quantum dot light-emitting display device, but is not limited thereto. The display device 1060 may be connected to other components through the buses or other communication links.

Also, the disclosure may be applied to a display device and an electronic device including the display device. For example, the disclosure may be applied to a digital TV, a 3D TV, a mobile phone, a smart phone, a tablet computer, a VR device, a PC, a home electronic device, a notebook computer, a PDA, a PMP, a digital camera, a music player, a portable game console, a navigation system, and the like.

As discussed, embodiments can provide a pixel comprising: a first transistor arranged to generate a driving current, and comprising a control electrode connected to a first node, a first electrode, and a second electrode connected to a second node; a second transistor comprising a control electrode arranged to receive a write gate signal, a first electrode for receiving a data voltage, and a second electrode connected to a third node; a first capacitor comprising a first electrode connected to the first node, and a second electrode connected to the third node; a second capacitor comprising a first electrode, and a second electrode connected to the third node; and a light-emitting element arranged to emit light by receiving the driving current.

The first electrode of the first transistor may be arranged to receive a power voltage.

The first node may be connected between the control electrode of the first transistor and the first electrode of the first capacitor.

The control electrode of the second transistor may be connected to a gate line.

The first electrode of the second transistor may be connected to a data line.

In some embodiments, the pixel comprises a third transistor comprising a control electrode arranged to receive a reference gate signal, a first electrode arranged to receive a reference voltage, and a second electrode connected to the first node. In some embodiments, the pixel comprises a third transistor comprising a control electrode arranged to receive a reference gate signal, a first electrode arranged to receive a first power voltage, and a second electrode connected to the first node.

In some embodiments, the pixel comprises a fourth transistor comprising a control electrode for receiving a reference gate signal, a first electrode connected to the second node, and a second electrode connected to the third node.

In some embodiments, the pixel comprises a fifth transistor comprising a control electrode arranged to receive a first emission signal, a first electrode arranged to receive a first power voltage, and a second electrode connected to the first transistor. The second electrode of the fifth transistor may be connected to the first electrode of the first transistor.

In some embodiments, the pixel comprises a sixth transistor comprising a control electrode arranged to receive a second emission signal, a first electrode connected to the first transistor, and a second electrode connected to the light-emitting element. The first electrode of the sixth transistor may be connected to the second electrode of the first transistor. The first electrode of the sixth transistor may be connected to the second electrode of the first transistor via the second node.

In some embodiments, the pixel comprises a seventh transistor comprising a control electrode arranged to receive a bias gate signal, a first electrode arranged to receive an initialization voltage, and a second electrode connected to the light-emitting element. In some embodiments, the pixel comprises a seventh transistor comprising a control electrode arranged to receive the first emission signal, a first electrode arranged to receive an initialization voltage, and a second electrode connected to the light-emitting element. In some embodiments, the seventh transistor comprises a type that is different from that of the fifth transistor.

In some embodiments, the first electrode of the second capacitor is connected to a fourth node. The fourth node may be connected between the sixth transistor and the light-emitting element.

In some embodiments, the second electrode of the seventh transistor may be connected to the fourth node.

Embodiments can provide a display device comprising: a display panel comprising a pixel; and a display panel driver configured to drive the display panel, wherein the pixel is according to any of the above described embodiments.

Embodiments can provide an electronic device comprising: a processor arranged to provide input image data; and a display device arranged to display an image based on the input image data, wherein the display device is according to any of the above described embodiments.

Embodiments can provide a display device comprising: a display panel comprising a pixel; and a display panel driver configured to drive the display panel, wherein the pixel comprises: a first transistor for generating a driving current, and comprising a control electrode connected to a first node, a first electrode, and a second electrode connected to a second node; a second transistor comprising a control electrode for receiving a write gate signal, a first electrode for receiving a data voltage, and a second electrode connected to a third node; a first capacitor comprising a first electrode connected to the first node, and a second electrode connected to the third node; a second capacitor comprising a first electrode, and a second electrode connected to the third node; and a light-emitting element for emitting light by receiving the driving current.

Embodiments can provide an electronic device comprising: a processor to provide input image data; and a display device to display an image based on the input image data, and comprising: a display panel comprising a pixel; and a display panel driver configured to drive the display panel, wherein the pixel comprises: a first transistor for generating a driving current, and comprising a control electrode connected to a first node, a first electrode, and a second electrode connected to a second node; a second transistor comprising a control electrode for receiving a write gate signal, a first electrode for receiving a data voltage, and a second electrode connected to a third node; a first capacitor comprising a first electrode connected to the first node, and a second electrode connected to the third node; a second capacitor comprising a first electrode, and a second electrode connected to the third node; and a light-emitting element for emitting light by receiving the driving current.

Although some embodiments and examples are described herein, these are provided only to facilitate a more general understanding of the disclosure, embodiments of the disclosure are not limited to the above-described embodiments, and those of ordinary skill in the field to which the disclosure pertains may variously correct and modify from such a description.

Therefore, the disclosure should not be limited to the described embodiments, and the claims described below and all modifications that are equal or equivalent to the claim may fall within the scope of the disclosure.

Although described with reference to the above embodiments, it will be understood that those skilled in the art can variously modify and change the disclosure without departing from the scope of the disclosure described in the claims below, with functional equivalents thereof to be included therein.

## Claims

1. A pixel comprising:
a first transistor arranged to generate a driving current, and comprising a control electrode connected to a first node, a first electrode, and a second electrode connected to a second node;
a second transistor comprising a control electrode arranged to receive a write gate signal, a first electrode for receiving a data voltage, and a second electrode connected to a third node;
a first capacitor comprising a first electrode connected to the first node, and a second electrode connected to the third node;
a second capacitor comprising a second electrode, and a first electrode connected to the third node; and
a light-emitting element arranged to emit light by receiving the driving current.

2. The pixel according to claim 1, further comprising a fourth transistor comprising a control electrode for receiving a reference gate signal, a first electrode connected to the second node, and a second electrode connected to the third node.

3. The pixel according to claim 1 or 2, wherein the first transistor is an N-channel metal oxide semiconductor, NMOS, transistor.

4. The pixel according to any one of claims 1 to 3, further comprising a seventh transistor comprising a control electrode for receiving a bias gate signal, a first electrode for receiving an initialization voltage, and a second electrode connected to the light-emitting element.

5. The pixel according to any one of claims 1 to 3, further comprising:
a fifth transistor comprising a control electrode arranged to receive a first emission signal, a first electrode arranged to receive a first power voltage, and a second electrode connected to the first transistor;
a sixth transistor comprising a control electrode arranged to receive a second emission signal, a first electrode connected to the first transistor, and a second electrode connected to the light-emitting element; and
a seventh transistor comprising a control electrode arranged to receive the first emission signal, a first electrode arranged to receive an initialization voltage, and a second electrode connected to the light-emitting element,
wherein the seventh transistor comprises a type that is different from that of the fifth transistor.

6. The pixel according to any one of claims 1 to 5, further comprising a third transistor comprising a control electrode arranged to receive a reference gate signal, a first electrode arranged to receive a reference voltage, and a second electrode connected to the first node.

7. The pixel according to any one of claims 1 to 6, further comprising a third transistor comprising a control electrode arranged to receive a reference gate signal, a first electrode arranged to receive a first power voltage, and a second electrode connected to the first node.

8. The pixel according to any one of claims 1 to 7, wherein the first transistor further comprises a back gate electrode connected to the second node.

9. The pixel according to any one of claims 1 to 8, wherein the first transistor further comprises a back gate electrode connected to an anode electrode of the light-emitting element.

10. The pixel according to any one of claims 1 to 9, further comprising:
a first electrode layer comprising the second electrode of the second capacitor;
a second electrode layer above the first electrode layer, and comprising the second electrode of the first capacitor and the first electrode of the second capacitor;
an additional electrode layer above the second electrode layer, and comprising a first electrode pattern comprising a back gate electrode of the first transistor, and a second electrode pattern comprising the first electrode of the first capacitor;
an active layer above the additional electrode layer, and comprising a channel area of the first transistor; and
a third electrode layer above the active layer, comprising the control electrode of the first transistor, and electrically connected to the second electrode pattern.

11. The pixel according to any one of claims 1 to 9, further comprising:
a first electrode layer comprising the first electrode of the first capacitor;
a second electrode layer above the first electrode layer, and comprising the second electrode of the first capacitor and the first electrode of the second capacitor;
an additional electrode layer above the second electrode layer, and comprising a first electrode pattern comprising a back gate electrode of the first transistor, and a second electrode pattern comprising the second electrode of the second capacitor;
an active layer above the additional electrode layer, and comprising a channel area of the first transistor; and
a third electrode layer above the active layer, comprising the control electrode of the first transistor, and electrically connected to the first electrode layer.

12. A display device comprising:
a display panel comprising a pixel; and
a display panel driver configured to drive the display panel,
wherein the pixel is according to any one of claims 1 to 11.

13. The display device according to claim 12 when dependent on claim 5, wherein the display panel driver is configured to adjust an off duty ratio of at least one of the first emission signal or the second emission signal according to an emission off ratio.

14. The display device according to claim 13 when dependent on claim 5, wherein the display panel driver is configured to adjust an off duty ratio of the second emission signal according to the emission off ratio.

15. An electronic device comprising:
a processor arranged to provide input image data; and
a display device arranged to display an image based on the input image data, wherein the display device is according to claim 14.
